# EUROPEAN PATENT APPLICATION

(11) **EP 4 693 392 A1**
(43) Date of publication of application: **11.02.2026**
(21) Application number: 24779857.2
(22) Date of filing: 21.03.2024
(51) Int. Cl.: H01L 23/14, H01L 23/36, H05K 1/02

(54) **SUBSTRATE FOR MOUNTING SEMICONDUCTOR ELEMENT**

(30) Priority: 30.03.2023 JP 2023055862
(71) Applicant: Niterra Co., Ltd., Nagoya-shi, Aichi 461-0005 (JP)
(72) Inventor: WATANABE, Yukihiro, Nagoya-shi, Aichi 461-0005 (JP); MURASE, Tatsunori, Nagoya-shi, Aichi 461-0005 (JP); USAMI, Kenzo, Nagoya-shi, Aichi 461-0005 (JP); KONDO, Yosuke, Nagoya-shi, Aichi 461-0005 (JP); NISHIMURA, Mitsuru, Nagoya-shi, Aichi 461-0005 (JP); SANO, Isuzu, Nagoya-shi, Aichi 461-0005 (JP)
(74) Representative: Cabinet Beau de Loménie
(86) International application number: PCT/JP2024/011070
(87) International publication number: WO 2024/203737

(57) **Abstract**

A semiconductor element mounting substrate includes a base formed of a metal, an electrode to be connected to a semiconductor element, and a protective layer disposed between the base and the electrode and formed of a material that is harder than the metal forming the base.

## Description

### Technical Field

The present invention relates to a semiconductor element mounting substrate.

### Background Art

Semiconductor element mounting substrates for mounting semiconductor elements are conventionally known. For example, PTL 1 discloses a semiconductor element mounting substrate including a metal-made base, an insulating layer, and an intermediate layer disposed between the base and the insulating layer.

### Citation List

### Patent Literature

PTL 1: Japanese Unexamined Patent Application Publication No. 7-240570

### Summary of Invention

### Technical Problem

However, even with the conventional technology such as that disclosed in PTL 1, there is still room for improvement in the technique for preventing the occurrence of problems caused by the deformation of the bases of semiconductor element mounting substrates. In the semiconductor element mounting substrate described in PTL 1, the base is formed of a metal that deforms relatively easily, and therefore the base may deform when a force is applied to the base during handling in a production process or during various inspections. Deformation of the base may lead to problems such as the formation of cracks in the insulating layer. There is therefore a demand for a technique that can prevent the deformation of the base.

It is an object of the present invention to provide a technique for preventing the occurrence of problems caused by the deformation of the base of a semiconductor element mounting substrate.

### Solution to Problem

The present invention has been made to solve at least part of the foregoing problem and can be embodied as the following aspects.
(1) One aspect of the invention provides a semiconductor element mounting substrate. The semiconductor element mounting substrate includes: a base formed of a metal; an electrode to be connected to a semiconductor element; and a protective layer disposed between the base and the electrode and formed of a material that is harder than the metal forming the base.
   In the structure described above, the protective layer disposed between the metal-made base and the electrode is formed of the material harder than the metal forming the base. In this case, even when a force that can deform the base is applied to the semiconductor element mounting substrate, the deformation of the base can be prevented. Therefore, the occurrence of problems caused by the deformation of the base can be prevented.
(2) In the semiconductor element mounting substrate in the above aspect, the protective layer may be formed of a metal. In the structure described above, the metal forming the protective layer is, for example, more resistant to cracking than ceramics. Therefore, the deformation of the base can be prevented more effectively, and the occurrence of problems caused by the deformation of the base can be prevented more effectively.
(3) In the semiconductor element mounting substrate in the above aspect, a rest potential of the material forming the protective layer in salt water may be higher than that of the metal forming the base. With the structure described above, even when the semiconductor element mounting substrate with a semiconductor element mounted thereon is actually used and, for example, splashed with salt water, the protective layer can prevent corrosion of the base.
(4) In the semiconductor element mounting substrate in the above aspect, the material forming the protective layer may be resistant to corrosion by sulfide gas. In the structure described above, when the semiconductor element mounting substrate with a semiconductor element mounted thereon is actually used, the protective layer can prevent corrosion of the base by sulfide gas present in the use environment.
(5) The semiconductor element mounting substrate in the above aspect may further include an insulating layer disposed between the base and the electrode, and the protective layer may be disposed between the base and the insulating layer. In the structure described above, the protective layer is formed before the formation of the insulating layer in the process of producing the semiconductor element mounting substrate, so that the deformation of the base can be prevented even before the formation of the insulating layer. Therefore, the occurrence of cracks in the insulating layer due to, for example, the deformation of the base can be prevented.
(6) In the semiconductor element mounting substrate in the above aspect, the insulating layer may be formed of any one of Al₂O₃, SiO₂, Y₂O₃, AlN, Si₃N₄, and SIC. In the structure described above, the insulating layer is formed of any one of Al₂O₃, SiO₂, Y₂O₃, AlN, Si₃N₄, and SIC. Therefore, the insulating performance of the insulating layer can be improved.
(7) The semiconductor element mounting substrate in the above aspect may further include an insulating layer disposed between the base and the electrode, and the protective layer may be disposed between the insulating layer and the electrode. In the structure described above, the protective layer can prevent, for example, a force acting on the electrode from acting on the insulating layer. Therefore, the insulating layer is prevented from breaking.
(8) In the semiconductor element mounting substrate in the above aspect, the insulating layer may be formed of any one of Al₂O₃, SiO₂, Y₂O₃, AlN, Si₃N₄, and SIC. In the structure described above, the insulating layer is formed of any one of Al₂O₃, SiO₂, Y₂O₃, AlN, Si₃N₄, and SIC. Therefore, the insulating performance of the insulating layer can be improved.
(9) In the semiconductor element mounting substrate in the above aspect, the base may be formed into a flat plate shape, and the protective layer may be formed on each of a pair of principal surfaces of the base. In the structure described above, even when a force that can deform the base is applied to the principal surface of the base that is on the side with no electrode formed thereon, the protective layer can prevent the deformation of the base.
(10) In the semiconductor element mounting substrate in the above aspect, the protective layer may have a thickness of 0.5 micrometers or more and 10 micrometers or less. With the structure described above, when the semiconductor element mounting substrate is used as a heat dissipation substrate for dissipating heat generated in the semiconductor element, the protective layer can prevent the deformation of the base without a reduction in heat dissipation performance.
(11) In the semiconductor element mounting substrate in the above aspect, the protective layer may contain a nickel-cobalt alloy, a nickel-phosphorus alloy, or a nickel-boron alloy. In the structure described above, the nickel-cobalt alloy, the nickel-phosphorus alloy, or the nickel-boron alloy contained in the protective layer can be formed by plating. Therefore, in the process of producing the semiconductor element mounting substrate, the protective layer can be formed relatively easily.
(12) In the semiconductor element mounting substrate in the above aspect, the base may be formed of a material containing copper or aluminum as a main component. In the structure described above, the base is formed of the material containing copper or aluminum, which has high heat dissipation performance, as a main component. Therefore, the heat dissipation performance of the semiconductor element mounting substrate can be improved.

The present invention can be embodied in various forms. For example, the invention can be embodied as products including the semiconductor element mounting substrate, a method for producing the semiconductor element mounting substrate, a method for inspecting the semiconductor element mounting substrate, etc.

### Brief Description of Drawings

[Fig. 1] Fig. 1 is a schematic cross-sectional view of a semiconductor element mounting substrate in a first embodiment.
[Fig. 2] Fig. 2 is a schematic cross-sectional view of a semiconductor package.
[Fig. 3] Fig. 3 is a schematic cross-sectional view of a semiconductor element mounting substrate in a second embodiment.
[Fig. 4] Fig. 4 is a schematic cross-sectional view of a semiconductor element mounting substrate in a third embodiment.

### Description of Embodiments

### <First embodiment>

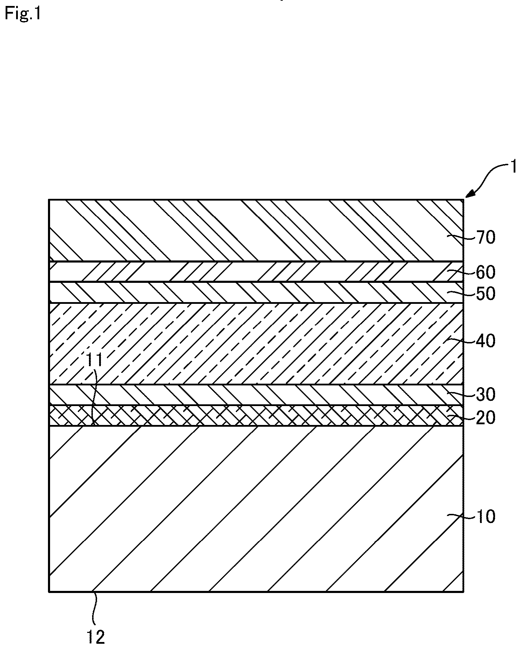

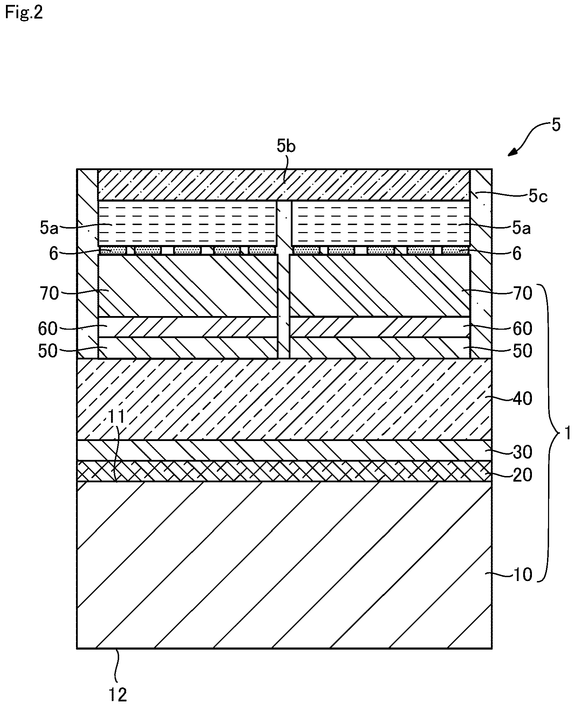

Fig. 1 is a schematic cross-sectional view of a semiconductor element mounting substrate 1 in a first embodiment. Fig. 2 is a schematic cross-sectional view of a semiconductor package 5 including the semiconductor element mounting substrate 1 in the first embodiment. The semiconductor element mounting substrate 1 in the present embodiment serves as a heat dissipation substrate that supports optical semiconductors such as light emitting diodes (LEDs) or semiconductor lasers (LDs: laser diodes) used as semiconductor elements 5a and that dissipates heat generated during light emission to the outside. The semiconductor element mounting substrate 1 includes a base 10, a protective layer 20, a contact layer 30, an insulating layer 40, a contact layer 50, a bonding layer 60, and an electrode 70. In Figs. 1 and 2, the base 10, the protective layer 20, the contact layer 30, the insulating layer 40, the contact layer 50, the bonding layer 60, the electrode 70, and the semiconductor elements 5a are drawn such that the relations among their thicknesses differ from the actual thickness relations, for the sake of convenience of description.

The base 10 is a member having a flat plate shape and serves as a support of the semiconductor element mounting substrate 1. In the present embodiment, the thickness of the base 10 is 1 mm. The base 10 is formed of a metal. In the present embodiment, the base 10 is formed of copper (Cu). The base 10 may be formed of a material containing copper as a main component, aluminum (Al), or a material containing aluminum as a main component. The term "main component" is a component contained in an amount of more than 50% by mass in the material of interest. The base 10 may be formed of an alloy of copper and aluminum. Since the base 10 is formed of any of these metals, the heat generated in the semiconductor elements 5a can be dissipated to the outside efficiently through the base 10.

The protective layer 20 is disposed between the base 10 and the electrode 70, more specifically between the base 10 and the contact layer 30. In the present embodiment, the protective layer 20 is disposed on one of a pair of principal surfaces 11 and 12 of the base 10, i.e., on the principal surface 11. The protective layer 20 is formed of a material harder than the metal forming the base 10. The "material harder than the metal forming the base 10" is, for example, a material having a higher Vickers hardness than the metal forming the base 10. In the present embodiment, the protective layer 20 is formed of a metal, which is more resistant to cracking than ceramics etc. Specifically, the protective layer 20 is formed of a metal containing a nickel-cobalt alloy (Ni-Co). In the present embodiment, the thickness of the protective layer 20 is 0.5 micrometers or more and 10 micrometers or less. In this case, the protective layer 20 can prevent the deformation of the base 10 while heat generated in the semiconductor elements 5a is allowed to transfer to the base 10. The protective layer 20 may be formed of a metal containing either a nickel-phosphorus alloy (Ni-P) or a nickel-boron alloy (Ni-B) or may be formed of tungsten (W) or molybdenum (Mo).

The material forming the protective layer 20 is a material whose rest potential in salt water is higher than that of copper forming the base 10. The "salt water" refers to water with a sodium chloride (NaCl) concentration of 5% by mass or less. In this case, even when the protective layer 20 comes into contact, in salt water, with a metal material such as copper, titanium (Ti), nickel, or cobalt that can be in electrical contact within the semiconductor element mounting substrate 1, corrosion is unlikely to occur.

The material forming the protective layer 20 is a material that is more resistant to corrosion by sulfide gas (H₂S) than copper forming the base 10. The "resistance to corrosion by sulfide gas" refers to the property of being resistant to corrosion by sulfide gas in an environment with a volumetric sulfide gas concentration of 15 ppm or less. In this case, the protective layer 20 can prevent the corrosion of the base 10 by sulfide gas in an actual use environment.

The contact layer 30 is disposed between the protective layer 20 and the insulating layer 40. In the present embodiment, the contact layer 30 is formed of titanium and has a thickness of, for example, 0.5 micrometers. The contact layer 30 allows the protective layer 20 and the insulating layer 40 to adhere closely to each other and prevents the formation of cracks in the insulating layer 40 due to the difference in thermal expansion coefficient.

The insulating layer 40 is disposed between the base 10 and the electrode 70, more specifically between the contact layer 30 and the contact layer 50. The insulating layer 40 is formed of any one of Al₂O₃, SiO₂, Y₂O₃, AlN, Si₃N₄, and SIC. In the present embodiment, the insulating layer 40 is formed of Al₂O₃ and has a thickness of, for example, 5 micrometers. The insulating layer 40 provides insulation between the metal-made base 10 and the electrode 70.

The contact layer 50 is disposed between the insulating layer 40 and the bonding layer 60. In the present embodiment, the contact layer 50 is formed of titanium and has a thickness of, for example, 0.2 micrometers. The contact layer 50 allows the insulating layer 40 and the bonding layer 60 to adhere closely to each other and prevents the formation of cracks in the insulating layer 40 due to the difference in thermal expansion coefficient.

The bonding layer 60 is disposed between the contact layer 50 and the electrode 70. The bonding layer 60 is formed of palladium (Pd) and has a thickness of, for example, 0.07 micrometers. The bonding layer 60 increases the bonding strength between the contact layer 50 and the electrode 70.

The electrode 70 is to be connected to the semiconductor elements 5a via bumps 6 (see Fig. 2). The electrode 70 is formed of gold (Au) and has a thickness of, for example, 3.0 micrometers.

The semiconductor package 5 includes the semiconductor element mounting substrate 1, the semiconductor elements 5a, a phosphor 5b, and a resin portion 5c (see Fig. 2). In the semiconductor package 5, the phosphor 5b is disposed on the semiconductor elements 5a connected to the semiconductor element mounting substrate 1 via the bumps 6 and is located on the side opposite from the semiconductor element mounting substrate 1. The phosphor 5b converts the wavelength of light emitted from the semiconductor elements 5a serving as optical semiconductors, and the resulting light is emitted to the outside. The resin portion 5c seals the semiconductor elements 5a and the phosphor 5b.

Next, a method for producing the semiconductor element mounting substrate 1 in the present embodiment will be described. First, a nickel-cobalt alloy is deposited on one side of a copper-made flat plate member used as the base 10 to form the protective layer 20. Then, the contact layer 30, the insulating layer 40, the contact layer 50, the bonding layer 60, and the electrode 70 are deposited in this order on the protective layer 20, and the semiconductor element mounting substrate 1 is thereby produced.

Next, the features of the semiconductor element mounting substrate 1 in the present embodiment will be described in relation to problems with a semiconductor element mounting substrate in a comparative example that does not include the protective layer 20. In the semiconductor element mounting substrate production process, a load is applied to the electrode of the semiconductor element mounting substrate in a probe test step, a chip mounting step, etc., and the base may be dented at a portion receiving the load. Moreover, when the semiconductor element mounting substrate is handled, a handling tool is brought into contact with the semiconductor element mounting substrate, and a force from the tool acts on the semiconductor element mounting substrate. Therefore, in the semiconductor element mounting substrate in the comparative example, the base may deform. When the base deforms, the insulating layer stacked on the base also deforms, and cracks may be formed in the insulating layer. The cracks in the insulating layer cause dielectric breakdown in the semiconductor element mounting substrate.

In the semiconductor element mounting substrate 1 in the present embodiment, the protective layer 20 formed of the material harder than the metal forming the base 10 is disposed between the base 10 and the electrode 70. In this case, even when a load is applied to the electrode 70 of the semiconductor element mounting substrate 1 during the process of producing the semiconductor element mounting substrate 1, the protective layer 20 resists deformation, and therefore the base 10 is unlikely to dent. Similarly, even when the tool comes into contact during handling and the force from the tool acts on the protective layer 20, the protective layer 20 resists deformation, so that the base 10 is unlikely to deform. Therefore, the insulating layer 40 also resists deformation, so that dielectric breakdown caused by the deformation of the base 10 is unlikely to occur in the insulating layer 40.

When the semiconductor element mounting substrate in the comparative example includes a chromium-made layer serving as an intermediate layer, electrons can easily migrate through the interface with metals contained in the semiconductor element mounting substrate in the comparative example because the rest potential of chromium in salt water is relatively low. Therefore, galvanic corrosion may occur. Since the chromium-made layer reacts excessively with an etching solution used to etch the electrode etc., over etching may occur.

The protective layer 20 included in the semiconductor element mounting substrate 1 in the present embodiment is formed of a nickel-cobalt alloy, whose rest potential in salt water is higher than that of copper forming the base 10. In this case, the potential difference between the base 10 and the protective layer 20 is small, and therefore corrosion by salt water and etching by the etching solution used in the production process are less likely to occur.

In the above-described semiconductor element mounting substrate 1 in the present embodiment, the protective layer 20 disposed between the copper-made base 10 and the electrode 70 is formed of a nickel-cobalt alloy, which is a material harder than copper forming the base 10. In this case, even when a force that can deform the base 10 acts on the semiconductor element mounting substrate 1 during the process of producing the semiconductor element mounting substrate 1 etc., the deformation of the base 10 can be prevented. Therefore, the occurrence of problems caused by the deformation of the base 10 can be prevented.

In the semiconductor element mounting substrate 1 in the present embodiment, the metal forming the protective layer 20 is more resistant to cracking than ceramics. In this case, the deformation of the base 10 can be prevented more effectively, and therefore the occurrence of problems caused by the deformation of the base 10 can be prevented more effectively.

In the semiconductor element mounting substrate 1 in the present embodiment, the protective layer 20 is formed of a nickel-cobalt alloy, whose rest potential in salt water is higher than that of copper forming the base 10. In this case, even if, for example, the base 10 is splashed with salt water during actual use of the semiconductor element mounting substrate 1 with the semiconductor elements 5a mounted thereon, the protective layer 20 can prevent corrosion of the base 10.

In the semiconductor element mounting substrate 1 in the present embodiment, the protective layer 20 is formed of a nickel-cobalt alloy, which is resistant to corrosion by sulfide gas. In this case, the protective layer 20 can prevent corrosion of the base 10 by sulfide gas present in a use environment during actual use of the semiconductor element mounting substrate 1 with the semiconductor elements 5a mounted thereon.

In the semiconductor element mounting substrate 1 in the present embodiment, the protective layer 20 is disposed between the base 10 and the insulating layer 40. In the process of producing the semiconductor element mounting substrate 1, the protective layer 20 is formed on the base 10 before the formation of the insulating layer 40. In this case, the deformation of the base 10 can be prevented before the formation of the insulating layer 40, and therefore the occurrence of cracks in the insulating layer 40 due to, for example, the deformation of the base 10 can be prevented.

In the semiconductor element mounting substrate 1 in the present embodiment, the thickness of the protective layer 20 is 0.5 micrometers or more and 10 micrometers or less. In the present embodiment, the semiconductor element mounting substrate 1 serves as a heat dissipation substrate for the semiconductor elements 5a. Therefore, by setting the thickness of the protective layer 20 to 10 micrometers or less, the protective layer 20 is prevented from serving as thermal resistance between the semiconductor elements 5a and the base 10. By setting the thickness of the protective layer 20 to 0.5 micrometers or more, the protective layer 20 can have certain strength, so that the deformation of the base 10 can be prevented.

In the semiconductor element mounting substrate 1 in the present embodiment, the protective layer 20 is formed of a nickel-cobalt alloy, which can be formed by plating. In this case, the protective layer 20 can be formed relatively easily in the process of producing the semiconductor element mounting substrate 1.

In the semiconductor element mounting substrate 1 in the present embodiment, the base 10 is formed of copper having relatively high heat dissipation performance, and therefore the heat dissipation performance of the semiconductor element mounting substrate 1 can be improved.

### <Second embodiment>

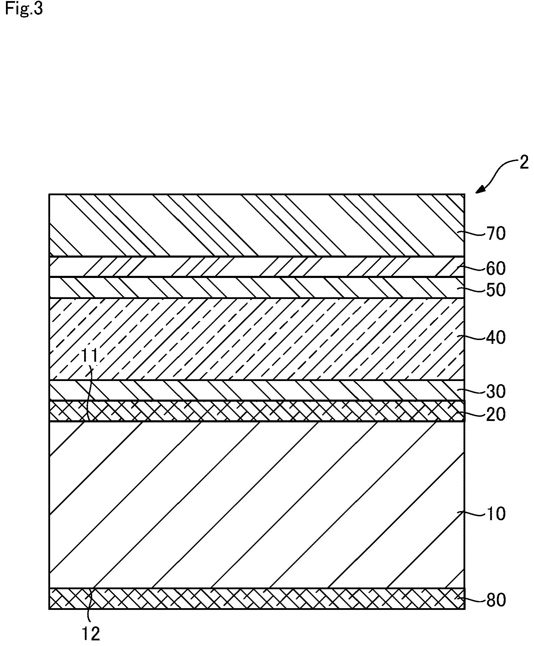

Fig. 3 is a cross-sectional view of a semiconductor element mounting substrate 2 in a second embodiment. The semiconductor element mounting substrate 2 in the second embodiment differs from the semiconductor element mounting substrate 1 in the first embodiment (Fig. 1) in that the protective layer is formed on each of the pair of principal surfaces of the base.

The semiconductor element mounting substrate 2 in the second embodiment includes a base 10, a protective layer 20, a contact layer 30, an insulating layer 40, a contact layer 50, a bonding layer 60, an electrode 70, and a protective layer 80. In Fig. 3, the base 10, the protective layer 20, the contact layer 30, the insulating layer 40, the contact layer 50, the bonding layer 60, the electrode 70, and the protective layer 80 are drawn such that the relations among their thicknesses differ from the actual thickness relations, for the sake of convenience of description.

The protective layer 80 is disposed on the base 10 having a flat plate shape and is located on the principal surface 12 on the side opposite from the side on which the electrode 70 is formed. Specifically, in the semiconductor element mounting substrate 2, the protective layers 20 and 80 are formed of a material harder than the metal forming the base 10 and are formed on the pair of principal surfaces 11 and 12, respectively, of the base 10. Like the protective layer 20, the protective layer 80 is formed of a metal containing a nickel-cobalt alloy.

In the above-described semiconductor element mounting substrate 2 in the present embodiment, the protective layer 20 formed of a nickel-cobalt alloy, which is a material harder than copper forming the base 10, is disposed between the base 10 and the electrode 70. Therefore, even when a load is applied to the electrode 70 during, for example, the chip mounting step in the process of producing the semiconductor element mounting substrate 1 etc., the base 10 can be prevented from denting or deforming.

In the semiconductor element mounting substrate 2 in the present embodiment, the protective layers 20 and 80 are formed on the pair of principal surfaces 11 and 12, respectively, of the base 10. In this case, even if a force that can deform the base 10 acts on the principal surface 12 of the base 10 located on the side on which the electrode 70 is not formed, the protective layer 80 can prevent the principal surface 12 of the base 10 from denting or deforming.

In the semiconductor element mounting substrate 2 in the present embodiment, the protective layers 20 and 80 formed of the same material are formed on the pair of principal surfaces 11 and 12, respectively, of the base 10. In this case, the base 10 is less likely to warp than a semiconductor element mounting substrate in which the protective layer 20 and the insulating layer 40 are formed only on one side of the base 10. Therefore, the deformation of the base 10 can be prevented more effectively.

### <Third embodiment>

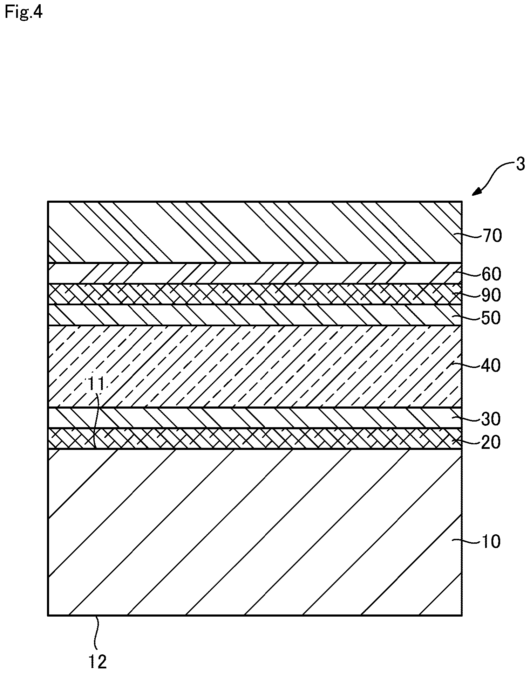

Fig. 4 is a cross-sectional view of a semiconductor element mounting substrate 3 in a third embodiment. The semiconductor element mounting substrate 3 in the third embodiment differs from the semiconductor element mounting substrate 1 in the first embodiment (Fig. 1) in that another protective layer is disposed between the insulating layer and the electrode.

The semiconductor element mounting substrate 3 in the third embodiment includes a base 10, a protective layer 20, a contact layer 30, an insulating layer 40, a contact layer 50, a protective layer 90, a bonding layer 60, and an electrode 70. In Fig. 4, the base 10, the protective layer 20, the contact layer 30, the insulating layer 40, the contact layer 50, the protective layer 90, the bonding layer 60, and the electrode 70 are drawn such that the relations among their thicknesses differ from the actual thickness relations, for the sake of convenience of description.

The protective layer 90 is disposed between the insulating layer 40 and the electrode 70, more specifically between the contact layer 50 and the bonding layer 60. The protective layer 90 is formed of a nickel-cobalt alloy, which is a material harder than the metal forming the base 10. In this case, the insulating layer 40 is unlikely to be deformed by a load applied to the electrode during the process of producing the semiconductor element mounting substrate 3 and by a force acting during handling.

In the above-described semiconductor element mounting substrate 3 in the present embodiment, the protective layer 20 formed of a nickel-cobalt alloy, which is a material harder than copper forming the base 10, is disposed between the base 10 and the electrode 70. Therefore, even when a load is applied to the electrode 70 during, for example, the chip mounting step in the process of producing the semiconductor element mounting substrate 1 etc., the base 10 can be prevented from denting or deforming.

In the semiconductor element mounting substrate 2 in the present embodiment, the protective layer 90 is disposed between the insulating layer 40 and the electrode 70. In this case, the protective layer 90 can prevent a load acting on the electrode 70 from acting on the insulating layer 40. Therefore, the insulating layer 40 can be prevented from breaking.

### <Modifications of embodiments>

The present invention is not limited to the embodiments described above and can be embodied in various other forms without departing from the scope of the invention. For example, the following modifications are possible.

### [Modification 1]

In the embodiments described above, the semiconductor element mounting substrate supports the optical semiconductors and serves as a heat dissipation substrate that dissipates the heat generated during light emission. However, the semiconductors mounted on the semiconductor element mounting substrate are not limited to the optical semiconductors.

### [Modification 2]

In the embodiments described above, the protective layers 20, 80, and 90 are formed of a metal containing a nickel-cobalt alloy, but the material forming the protective layers is not limited to the above material. It is only necessary that each protective layer be formed of any material that is harder than the metal forming the base. Since the protective layers are formed of the metal, they are resistant to cracking, so that the deformation of the substrate can be prevented more effectively. Since the protective layers contain a nickel-cobalt alloy, the protective layers can be formed relatively easily in the production process.

### [Modification 3]

In the embodiments described above, the protective layers 20, 80, and 90 are formed of the material whose rest potential in salt water is higher than that of copper forming the base 10. Since each protective layer is formed of the material whose rest potential in salt water is higher than that of the material forming the base, corrosion of the base 10 by salt water during actual use can be prevented. However, the material forming the protective layers is not limited to the above material.

### [Modification 4]

In the embodiments described above, the protective layers 20, 80, and 90 are formed of the material resistant to corrosion by sulfide gas. Since the protective layers are formed of the material resistant to corrosion by sulfide gas, corrosion of the base by sulfide gas in the actual use environment can be prevented. However, the material forming the protective layers is not limited to the above material.

### [Modification 5]

In the embodiments described above, the thickness of each protective layer is 0.5 micrometers or more and 10 micrometers or less, but the thickness of each protective layer is not limited thereto. However, if the thickness of the protective layer is less than 0.5 micrometers, it is difficult to prevent the deformation of the base 10. If the thickness of the protective layer is more than 10 micrometers, the protective layer serves as thermal resistance between the semiconductor elements 5a and the base 10, so that the ability to dissipate heat in the semiconductor elements 5a deteriorates. Therefore, the thickness of the protective layer is preferably 0.5 micrometers or more and 10 micrometers or less.

### [Modification 6]

In the embodiments described above, each protective layer formed of a material containing a nickel-cobalt alloy is formed in a plating step in the semiconductor element mounting substrate production process. However, the method of forming each protective layer is not limited to the above method. A deposition method such as a CVD (Chemical Vapor Deposition) method, an ALD (Atomic Layer Deposition) method, a PVD (Physical Vapor Deposition) method, or a vacuum vapor deposition method may be used.

### [Modification 7]

In the first embodiment, the semiconductor element mounting substrate 1 includes one protective layer 20 on the principal surface 11 side. In the third embodiment, the semiconductor element mounting substrate 3 includes two protective layers 20 and 90 on the principal surface 11 side. The number of protective layers included in each semiconductor element mounting substrate is not limited to the above numbers.

### [Modification 8]

In the first embodiment, the protective layer 20 is disposed between the base 10 and the insulating layer 40. In the third embodiment, the protective layer 20 is disposed between the base 10 and the insulating layer 40, and the protective layer 90 is disposed between the insulating layer 40 and the electrode 70. However, only the protective layer disposed between the insulating layer 40 and the electrode 70 may be used.

### [Modification 9]

In the embodiments described above, the insulating layer 40 is formed of Al₂O₃. However, the material forming the insulating layer is not limited to Al₂O₃. Preferably, the insulating layer 40 is formed of any one of SiO₂, Y₂O₃, AlN, Si₃N₄, and SIC. However, the insulating layer 40 may be formed of a material other than these metal compounds.

Although the aspects of the invention have been described based on the embodiments and modifications, the above-described embodiments of the aspects of the invention are provided so as to facilitate the understanding of the aspects and do not limit the aspects. The aspects of the invention can be changed or improved without departing from the gist of the aspects and the scope of the claims and encompass equivalents thereof. Some of the technical features of the aspects of the invention may be appropriately eliminated unless they are described as essential features in the present specification.

### (Application Example 1)

A semiconductor element mounting substrate including:
a base formed of a metal;
an electrode to be connected to a semiconductor element; and
a protective layer disposed between the base and the electrode and formed of a material that is harder than the metal forming the base.

### (Application Example 2)

The semiconductor element mounting substrate in accordance with Application Example 1, wherein the protective layer is formed of a metal.

### (Application Example 3)

The semiconductor element mounting substrate in accordance with Application Example 1 or 2, wherein a rest potential of the material forming the protective layer in salt water is higher than that of the metal forming the base.

### (Application Example 4)

The semiconductor element mounting substrate in accordance with any one of Application Examples 1 to 3, wherein the material forming the protective layer is resistant to corrosion by sulfide gas.

### (Application Example 5)

The semiconductor element mounting substrate in accordance with any one of Application Examples 1 to 4, further including an insulating layer disposed between the base and the electrode,
wherein the protective layer is disposed between the base and the insulating layer.

### (Application Example 6)

The semiconductor element mounting substrate in accordance with any one of Application Examples 1 to 5, wherein the insulating layer is formed of any one of Al₂O₃, SiO₂, Y₂O₃, AlN, Si₃N₄, and SIC.

### (Application Example 7)

The semiconductor element mounting substrate in accordance with any one of Application Examples 1 to 6, further including an insulating layer disposed between the base and the electrode,
wherein the protective layer is disposed between the insulating layer and the electrode.

### (Application Example 8)

The semiconductor element mounting substrate in accordance with any one of Application Examples 1 to 7, wherein the insulating layer is formed of any one of Al₂O₃, SiO₂, Y₂O₃, AlN, Si₃N₄, and SIC.

### (Application Example 9)

The semiconductor element mounting substrate in accordance with any one of Application Examples 1 to 8, wherein the base is formed into a flat plate shape, and
wherein the protective layer is formed on each of a pair of principal surfaces of the base.

### (Application Example 10)

The semiconductor element mounting substrate in accordance with any one of Application Examples 1 to 9, wherein the protective layer has a thickness of 0.5 micrometers or more and 10 micrometers or less.

### (Application Example 11)

The semiconductor element mounting substrate in accordance with any one of Application Examples 1 to 10, wherein the protective layer contains a nickel-cobalt alloy, a nickel-phosphorus alloy, or a nickel-boron alloy.

### (Application Example 12)

The semiconductor element mounting substrate in accordance with any one of Application Examples 1 to 11, wherein the base is formed of a material containing copper or aluminum as a main component.

### Reference Signs List

1, 2, 3 semiconductor element mounting substrate
10 base
11, 12 principal surface
20, 80, 90 protective layer
40 insulating layer
70 electrode

## Claims

1. A semiconductor element mounting substrate comprising:
a base formed of a metal;
an electrode to be connected to a semiconductor element; and
a protective layer disposed between the base and the electrode and formed of a material that is harder than the metal forming the base.

2. The semiconductor element mounting substrate in accordance with claim 1, wherein the protective layer is formed of a metal.

3. The semiconductor element mounting substrate in accordance with claim 1 or 2, wherein a rest potential of the material forming the protective layer in salt water is higher than that of the metal forming the base.

4. The semiconductor element mounting substrate in accordance with claim 1 or 2, wherein the material forming the protective layer is resistant to corrosion by sulfide gas.

5. The semiconductor element mounting substrate in accordance with claim 1 or 2, further comprising an insulating layer disposed between the base and the electrode,
wherein the protective layer is disposed between the base and the insulating layer.

6. The semiconductor element mounting substrate in accordance with claim 5, wherein the insulating layer is formed of any one of Al₂O₃, SiO₂, Y₂O₃, AlN, Si₃N₄, and SIC.

7. The semiconductor element mounting substrate in accordance with claim 1 or 2, further comprising an insulating layer disposed between the base and the electrode,
wherein the protective layer is disposed between the insulating layer and the electrode.

8. The semiconductor element mounting substrate in accordance with claim 7, wherein the insulating layer is formed of any one of Al₂O₃, SiO₂, Y₂O₃, AlN, Si₃N₄, and SIC.

9. The semiconductor element mounting substrate in accordance with claim 1 or 2, wherein the base is formed into a flat plate shape, and
wherein the protective layer is formed on each of a pair of principal surfaces of the base.

10. The semiconductor element mounting substrate in accordance with claim 1 or 2, wherein the protective layer has a thickness of 0.5 micrometers or more and 10 micrometers or less.

11. The semiconductor element mounting substrate in accordance with claim 1 or 2, wherein the protective layer contains a nickel-cobalt alloy, a nickel-phosphorus alloy, or a nickel-boron alloy.

12. The semiconductor element mounting substrate in accordance with claim 1 or 2, wherein the base is formed of a material containing copper or aluminum as a main component.
